(19)

Europäisches
Patentamt
European
Patent Office
Office européen
des brevets

(11) **EP 3 413 466 A1**

(12) **EUROPEAN PATENT APPLICATION**

(43) Date of publication:
**12.12.2018 Bulletin 2018/50**

(51) Int Cl.:
***H03M 1/06*** *(2006.01)*     *H03M 1/36* *(2006.01)*
***H03M 1/08*** *(2006.01)*

(21) Application number: **17174584.7**

(22) Date of filing: **06.06.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Smart Grid Solutions GmbH
60594 Frankfurt am Main (DE)**

(72) Inventors:
• **Santrac, Branislav
21000 Novi Sad (RS)**
• **Antic, Boris
21000 Novi Sad, (RS)**

(74) Representative: **König, Gregor Sebastian et al
König-Szynka-Tilmann-von Renesse
Patentanwälte Partnerschaft mbB
Mönchenwerther Straße 11
40545 Düsseldorf (DE)**

(54) **PARALLEL ADC CIRCUIT**

(57) The invention relates to a parallel ADC circuit comprising a reference voltage ladder providing a plurality of reference voltages, comparators, each of the comparators comprising two inputs, one coupled to an input terminal receiving a signal corresponding to an analogue input signal and coupled to the reference voltage ladder, and an encoder coupled to the comparators, wherein connectors are capable of toggling the inputs of the comparators.

EP 3 413 466 A1

**Description**

The invention relates to a parallel ADC circuit, to a use of a circuit for converting an analogue signal to a digital signal, and to a method for converting an analogue to a digital signal.

The invention relates in general to the field of operational amplifiers and instrumentation amplifiers, more specific to a circuit for error compensation of parallel analogue to digital converters (ADCs), the circuit can be used as part of a measurement device providing a digital signal from an analogue source signal.

The majority of precise digital instruments based on signal oversampling, and particularly those that rely on stochastic resonance can only utilize fast analogue-to-digital converters (ADCs) known as parallel ADCs. A typical parallel ADC uses $2^m$-1 operational amplifiers (OAs) set as comparators to produce $2^m$ different digital states. Each OA in the ADC commonly has the measured signal led to its plus input and a different comparison voltage led to its minus input. The number of distinct states of all OAs' outputs that equals $2^m$ is called the resolution of the ADC and m is called the number of bits.

A very simple and straightforward conversion of analogue signals combined with an intuitive interpretation and simple coding of their digital representations made parallel ADCs a favourite choice of all major instrument manufacturers. However, any application of the parallel ADCs also has at least two major drawbacks: First, high resolution can only be achieved through exponentially increasing hardware complexity and second, the OAs used in parallel ADCs are prone to significant variations in characteristics over time, particularly concerning their DC offsets. While the hardware complexity and the fluctuating errors can be compensated for instance by stochastic resonance methods, the offsets of OAs are difficult to deal with due to the unpredictability of some phenomena such as the aging of components, temperature fluctuations, dependence on the input signal, etc.

The most significant effect of non-zero offsets within a parallel ADC is the unpredictable bias of the converted voltage value. The OA, having its comparator voltage closest to the input signal finally determines the output digital value represented by a binary signal in form of a code word. But it will also inevitably add its offset to the input signal and the result typically is a digital value or code word corresponding to the sum of the offset and input level rather than a precise value of the input signal.

The severity of the offset is rather relative and it depends on the resolution of the ADC. The same offset error in a high-resolution ADC with a small quantisation or step size has a more significant effect than it would have in a small-resolution ADC with a considerably high quantisation or step size. In extreme cases, a parallel ADC having offsets equal to or greater than one half of the step size can exhibit non-predictable behaviour. For instance, two adjacent OAs could be triggered, instead of only one, producing a non-defined (forbidden) digital value or code word at the output. This effect is known as the bubble effect.

It is also known that it is not possible to design an OA which will preserve a zero offset indefinitely. Input offset voltage varies with temperature. Typical drift values for a range of general purpose precision OAs are typically in the range of 1-10 $\mu$V/°C. The offset also changes as time passes. Aging is generally specified in $\mu$V/month or $\mu$V/1000 hours and it is proportional to the square root of the elapsed time. Long-term stability of OAs is approximately 0.3 $\mu$V/month. Excluding the initial hour of operation, changes in the offset voltage of these devices during the first 30 days of operation are typically less than 2 $\mu$V. Performing a re-calibration of instruments operating non-stop for 20 years, measurement errors can increase from 5 to 10 times for low-resolution ADCs with 2-bit and 4-bit. When 8-bit and 10-bit ADCs are utilized even greater errors of the measurement uncertainty in time are expected due to their higher sensitivity regarding offset errors.

There are several known mechanisms to compensate for OAs' offsets. One possibility is to provide special pins available for optional offset null. To make use of the feature, two pins are connected using a potentiometer, and the wiper is led to one of the supply voltages through a resistor. If an OA doesn't have offset adjustment pins, an external compensation can be performed. With an inverting OA configuration, injecting current into the inverting input is the simplest method. The disadvantage is that there is a significant increase in noise gain.

Alternatively, US 6518898 B1 discloses an approach for offset voltage trimming. For this, a digital code is entered into the device to adjust the offset voltage to less than 1 mV, depending upon the grade. The most efficient method implemented so far is a chopper stabilization or auto-zero method for offset compensation that is disclosed in US 7193545 B2. The best bipolar amplifiers offer offset voltages of approximately 25 $\mu$V and 0.1 $\mu$V/°C drift. Offset voltages less than approximately 5 $\mu$V with practically no measurable offset drift are obtainable with choppers.

In case of a high-resolution, for instance 10-bit resolution, an ADC requires thousands of operational amplifiers (e.g. $2^{10}$ = 1024). Furthermore, most previous solutions are not practical or not efficient over lifetimes of many years, but also counterproductive. This is due to the fact, that components added for offset compensation (voltage sources, passive resistors) are usually more prone to short-time deviations from their nominal values due to actual and temperature sensitivity. Some of them require manual intervention and balancing between thousands of offsets and their possible values, which is extremely time consuming.

In case of both manual and automatic offset compensation, it is necessary to interrupt the measurement in order to perform the calibration or self-calibration. When non-stop 24/7 measurements are required, this is not an option. Alternatively, users can have back-up instruments for out-of-operation time. But such a solution requires a complex synchronization between devices, for example in order to prevent simultaneous auto-scheduled self-calibration. Also it is the most expensive solution possible.

In most advanced chopper-based OAs, the switching action produces small transient signals at the chopping frequency that can mix with the input signal frequency and produce intermodulation distortion. Therefore, in order to take advantage of the chopper OAs, much filtering is required. Otherwise the total noise of a chopper is typically worse than a high-quality bipolar OA.

The bubble effect is commonly reduced using majority-of-three (MoT) logical circuits. These circuits suppress possible non-defined (forbidden) code words of the natural thermometer code of the parallel ADC. For example, if instead of a regular thermometer code word 0011111 a forbidden code word 0101111 is obtained, the MoT circuit will output a correct code word 01000 in both cases. It has to be noted, that the MoT circuit artificially reduces the resolution of the ADC, so an additional 0 has to be added to the input of the upmost MoT. Almost all parallel ADC manufacturers rather opt for bubble error filters comprising NAND circuits since they are much simpler (occupy less space on a chip) and are cheaper to produce. However, they are not as effective as MoT circuits and can still generate forbidden code words.

The above mentioned approaches for improving parallel ADCs have vital drawbacks, particularly as they fail to produce on-the-fly corrections without interrupting the measurement process and they concentrate solely on offset compensation.

Given this background, the problem to be solved by the invention is to provide an improved and/or more efficient analogue to digital conversion.

This problem is solved by the subject matter of the independent claims. Preferred embodiments are described in the dependent claims and in the description following hereafter.

The general concept or core idea of the invention is to allow for a two phase analogue to digital conversion and to use the same comparators in the two phases. The difference between the two phases is that the inputs of the comparators are toggled. By averaging the result of the two phases a possible error can be reduced because the same comparators are used for the conversion in the two phases. The inventors were the first to considered a two-phase conversion, which could not be performed or introduced into existing parallel ADCs available on the market since they all have "+" inputs of all their comparators which are realized as OAs and short-circuited and led to a single input pin. Without an external access to individual "+" inputs of each comparator, it is not possible to introduce the necessary commutation through a toggling or switching component.

The parallel ADC circuit according to the invention comprises at least a reference voltage ladder providing a plurality of reference voltages and comparators each comprising two inputs. One input is coupled to an input terminal for a signal corresponding to the analogue signal and one input is coupled to the reference voltage ladder. The circuit further comprises at least one encoder coupled to the comparators and capable of encoding the signals received from the comparators. The circuit comprises connectors capable of toggling the inputs of the comparators.

Advantages of the circuit are listed in the following. The main advantage can be given by on-the-fly compensation of component's imperfections and aging without the need for manual or auto-calibration. A further benefit can be, that there is no need for fine tuning of components to compensate for manufacturing imperfections and tolerances. The proposed circuit can also allow for a simultaneous compensation of all other sources of asymmetry and bias in the analogue part of the ADC. The compensated offset doesn't necessarily have to refer only to the bias of the comparator (which can be an OA) and its internal components. Additional sources of bias are given, for instance, by low-frequency 1/f pink noise, non-evenly spaced comparison voltages due to imperfections of the resistor network and/or resistor heating due to constant DC dissipation through them. Further sources of bias are given by asymmetry and/or glitches and ripple in the power supply, but also by offsets present in switching components utilised to commute "+" and "-" inputs of each operational amplifier. Additionally, miscellaneous external sources of asymmetry can be reduced or even compensated as well by the proposed circuit. The combined effect of all sources of bias can be simplified summarized as $offset_k$ in this description. A further advantage of the invention can be a significantly lower probability of non-defined states and forbidden code words.

Consequently, this opens up a variety of applications for considerably fast and precise analogue to digital conversion that could have not thought of before. For instance the majority of precise digital instruments based on signal oversampling, and particularly those that rely on stochastic resonance, require such simultaneously fast and precise circuits. The invention can also be suitable to be utilized with circuits for precise extraction and high-factor multiplication of a fundamental frequency, for instance for precise measurements of spectral signal data or power measurements in power grids.

In this description, the notion "coupled" denotes an electric connection between two elements or components of a circuit. The term "coupled" encompasses a direct or indirect connection. The term "direct connection" encompasses that the connection is substantially without any element or component there between other than the wiring itself. The term "indirect connection" encompasses that the connection comprises further active or passive electric elements for adapting and/or optimizing an electric signal.

The term "parallel ADC circuit" encompasses a circuit which comprises a series of comparators, each one comparing an input voltage to a reference voltage. The comparators outputs can be connected to inputs of an encoder, which then can generate a binary output.

The term "corresponding to" (and relating grammatical adaptations) in the description encompasses the term "relating to", "equal to" and/or "proportional to". The term "corresponding" encompasses the meaning that a respective signal is not substantially changed with regard to the specific characteristics of the signal. A signal corresponding to a further signal might be a filtered, amplified, shifted, damped or otherwise processed signal without substantial variation of the feature of interest. With this regard, the term "equal to" relating to signals encompasses the meaning that the signals are substantially equal with regard to the feature of interest.

The term "voltage ladder" or "reference voltage ladder" in the description encompasses an electronic circuit or part of an electronic circuit comprising at least two resistors connected in series. A voltage can be applied across the resistors.

The term "encoder" in the description encompasses a device or circuit that converts information from one format or code to another. Especially, the encoder according to the description can receive one or more signals to generate a code word, especially a code word corresponding to the digital signal which is to be generated by the parallel ADC circuit.

The term "comparator" in the description encompasses a device or circuit that compares two voltages or currents and outputs a digital signal which can indicate which one of the two inputs is larger. Preferably, a comparator according to the description can be implemented as an operational amplifier.

The term "operational amplifier" in the description encompasses a device or circuit which is capable to act as a DC-coupled (high-gain) electronic voltage amplifier having a differential input and at least an output. An operational amplifier in an open loop circuit acts as a comparator.

The term "comprising" (and relating grammatical adaptations) encompasses the usual meaning of "comprising" (indicating a non-exhaustive list) as well as the meaning of "consisting" (indicating an exhaustive list).

The notion "clock" encompasses a clock generator or circuit which is especially capable of producing a timing signal. Especially, the signal can be a rectangular, square or sinusoidal wave. The clock can be adapted as or comprising a frequency generator or oscillator that preferably has a high temporal stability. The signal generated by the clock can be a periodic or a non-periodic signal. The term clock encompasses as well an electronic circuit which receives an (external) signal which is a timing signal and processes the signal to generate a (further) timing signal, for example a frequency divider.

The term "voltage limiter" encompasses an electronic device which is adapted to limit the voltage to a certain threshold, that typically means that voltages above the threshold are reduced to said threshold. It can also be thought of a voltage limiter that is capable of sending out a signal when the actual voltage is below and/or equal and/or higher than said threshold.

The notion "adder-based shift register" usually comprises an electronic device that can receive electric signals, optionally store them and preferably perform changes on said electric signal, typically in form of numerical operations. The received signal, that is typically changed, is then transferred to an output that can preferably allow different signal transmission standards. In a special embodiment, the adder-based shift register performs a numerical processing of the received values by averaging out code words of two preferably subsequent conversion phases, realised by shifting the converted value one bit to the right and adding this value to its previous content.

Every electrical component referred to in this description can comprise an impedance, which means a complex resistance that can cause a change of amplitude and phase. In the same way, each electrical component can comprise not only a linear, but also a non-linear behavior. Non-linear in the context of electrical components or elements means, that, for instance, new frequencies are generated that were not available in the input signal of the specific electrical component before.

Furthermore, a reference voltage ladder typically comprises a plurality of stable reference voltages. Preferably, each reference voltage comprises a tap and is highly stable since instabilities directly affect the result of the comparator and thus the result of the AD-conversion. Especially preferable, the reference voltage ladder comprises a plurality of stable reference voltages that are equally spaced concerning the voltage difference. In special embodiment, each reference voltage can be a separate voltage source that can even be independent of the others and/or controlled externally and/or coupled in a linear or even nonlinear manner with other reference voltage sources. It can also be thought of reference voltages that are varying in time. In a special embodiment, the variation of the reference voltages is coupled and/or synchronized with other reference voltages and/or other electric components.

Preferably, the comparators are formed as operational amplifiers which can result in a easy to manufacture device and/or a device which can be particularly suitable with regard to the purpose and the combination of the further used elements or devices in the circuit.

Preferably, the circuit further comprises logical circuits. Each of the logical circuits comprises a first input coupled to the output of one of the comparators and an output coupled to the encoder. The logical circuits can be used in the two phases to correct the result of the comparators such that the inversion of the inputs of the two comparators results in the correct signal. For example, a logical circuit can be an exclusive-OR circuit, a first input of the exclusive-OR circuit coupled to an operational amplifier output, a second input of the exclusive-OR circuit coupled to a clock, wherein during the two phases the second input is stable and altered between the two phases. The output of the exclusive-OR circuit can be coupled to the encoder.

Preferably, a first clock is coupled to a sample and hold circuit and the logical circuits, the sample and hold circuit can provide an analogue input signal, and the first clock has a frequency half of the frequency of a second clock, the second clock being coupled to the first clock and coupled to the connectors as an in input for the clock signal. This combination and connection of elements or circuits results in a easy to manufacture circuit providing stable clock signals and/or a good result of the conversion. The sample and hold circuit offers the possibility to hold the value of the analogue signal for a specified minimum period of time (preferably given by the first clock). In the context of the description, the term "sample and hold circuit" encompasses a circuit as an analogue device that samples the voltage of a analogue signal, which preferably continuously varies, and holds its value at the constant level. A "sample and hold circuit" can be used to eliminate variations in the input signal that can corrupt the conversion process, however, the sample and hold circuit according to the description holds the analogue signal for a specified time period, which can be given by the first clock. Thus, the connectors can comprise a clock input in order to allow triggering of the toggling or swapping according to the time signal of the second clock, while the first clock is coupled to the sample and hold circuit. Preferably, the first clock can be coupled to the logical circuits. Thus, two clocks can be used which are easy to handle because one of the clocks uses the time signal of the other clock to generate its respective time signal. For triggering or in general for signal transmission in the proposed parallel ADC circuit, it can be thought of various transmission standards such as NIM or TTL.

Preferably, one of the clocks, most preferably the first clock, comprises a JK-flip-flop which is simple in manufacture and an electronic component which is reliable and stable. The first clock can comprise a frequency divider dividing the frequency of the signal of the second clock by a factor K, wherein K is preferably an integer, particularly 2 which means that the first clock can generate a signal having a frequency which is half the frequency of the second clock. But the parameter K can - in general - also comprise a real or complex number. The clock realized as a frequency divider or a JK-flip-flop can be fed by a further clock (the other of the two clocks) which generates a clock signal. The inputs of a JK-flip-flop can be at constant "1" and the CLK input is coupled to the other clock.

Preferably, the circuit comprises a data processing unit receiving signals coupled to the encoder. The data processing unit preferably is able to store data and perform arithmetic mathematical operations of the received data.

Preferably, the data processing unit comprises an adder-based shift register. The adder-based shift register can comprise an input for receiving data, and an input for a reset signal and an input for a clock signal. In a preferred embodiment, the reset input is coupled to the first clock and the clock input is coupled to the second clock. Preferably, the adder-based shift register represents a data processing unit that can perform arithmetic operations such as an addition and or multiplication, in particular an averaging operation, of the received data. It can also be thought of that the data processing unit can apply any kind of mathematical function or mathematical distribution on the received data.

In a preferred embodiment, the parallel ADC circuit further comprises one or more voltage limiters that are coupled to the output of the operational amplifiers. A voltage limiter preferably comprises a logical conditioner that typically produce logical "1s" at +5 V (TTL level) from $+V_{cc}$, and logical "0s" at 0 V (TTL level) from $-V_{cc}$. However, if the operational amplifiers are designed as unipolar with TTL logical levels, it can be thought of that the voltage limiters can be omitted.

In a further preferred embodiment, the parallel ADC circuit additionally comprises one or more logical checking circuits, preferably adapted as majority-of-three (MoT) logical circuits, coupled between the output of one or more operational amplifiers and/or the output of the logical circuits and the encoder. The logical checking circuits can be especially used in case of a reference voltage ladder with preferably equal and in particular linear voltage drops, the parallel strands of a parallel ADC typically correspond to neighbouring bits of the AD conversion. Therefore, with the aforementioned connection, a MoT logical circuit can ensure a proper thermometer code (unary coding) even in cases of bubble errors. The up-most MoT circuit preferably has an added fixed "0" input to preserve the resolution of the converter.

Furthermore, a low pass filter can be coupled to one or more of the voltage limiters to eliminate high-frequency switching noise of the connectors. One input pin of each logical circuit is preferably connected to the signal of the first clock and will be set to logical "0" during this phase, making all logical circuits logically neutral.

The described parallel ADC circuit can be used in a measurement device. It can be thought of applying the corresponding measurement device for detection of the frequency for spectroscopic applications or in a power grid. The invention can also be implemented in any device using high-resolution highspeed analogue-to-digital conversion of signals at sampling rates up to 10 MHz or even further. These can comprise for instance high-precision laboratory instruments, medical diagnostic equipment, audio devices, sample rate converters, HDTV cameras, high-definition video and 4k video recorders, low frequency spectrometers and/or sensor transducers, house appliances, ADC for industrial micro-controllers and ADCs in automotive industry.

The invention further provides a use of a circuit for converting an analogue signal to a digital signal, said circuit comprising comparators, wherein a first AD-conversion with the comparators is performed, and a second AD-conversion with toggled inputs of the comparators is performed, and the results of the two AD-conversions is averaged.

The invention also provides a method for converting an analogue signal to a digital signal, using comparators, wherein a first AD-conversion with the comparators is performed, and a second AD-conversion with toggled inputs of the comparators is performed, wherein the results of the two AD-conversions is averaged.

Fig.1      shows a block diagram of a parallel ADC according to an embodiment of the present invention.

Fig. 2      shows a block diagram of a voltage limiter.

Fig. 3      illustrates binary signal values related to the block diagram of Fig. 1.

Fig. 4      gives a further illustration of signal values related to the block diagram of Fig. 1.

For further reference, lowercase letter label "i" in the index of a reference sign indicates that the respective denoted component or element is present in the circuit m times, wherein m is the number of bits of the parallel ADC.

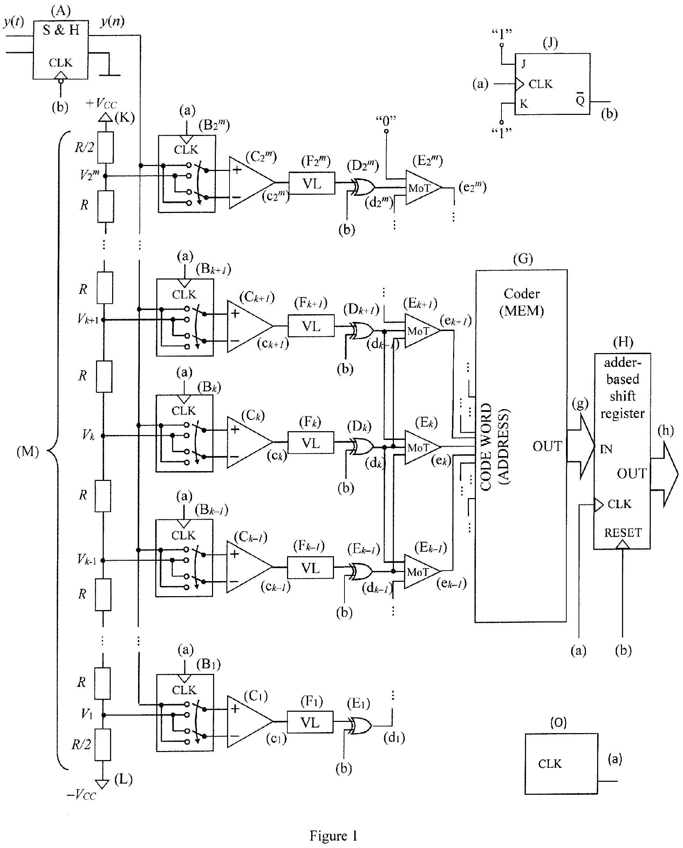

Figure 1 shows a block diagram of the parallel ADC according to an embodiment of the present invention. A first clock (J), realized as a JK flip-flop, is connected to an external CLK signal (a) of a second clock (O) and produces a halved frequency digital output signal (b) enabling two phases of the conversion of the same sample of an analogue signal which is to be converted. During a first phase the output signal (b) of the first clock (J) is equal to "1" and during the second phase the output signal (b) of the first clock (J) is equal to "0".

The analogue signal y(t) is connected to an analogue input of a sample and hold circuit (A). During the first phase the sample and hold circuit (A) will sample one value of the signal y(t) and it will produce a constant sampled value y(n).

The output signal (b) of the first clock (J) is fed to the CLK input of said sample and hold circuit (A). Thus, the output of the first clock (J) is coupled to the CLK input of the sample and hold circuit (A). Further, the output of the first clock (J) is coupled to the RESET input of a data processing unit (H), which is realized as an adder-based shift register, and the output of the first clock (J) is coupled to one input of a logical circuit ($D_i$), each of them realized as XOR circuit. The second clock (O), providing the external CLK signal (a), is connected to the CLK input of each connector ($B_i$), each of them realized as switch, and the CLK signal input of the data processing unit (H).

A supply voltage (K) and a supply voltage (L) are connected to opposite ends of a reference voltage ladder (M), having its reference voltage outputs $V_i$ connected to analogue inputs of each respective connector ($B_i$).

The analogue output of the sample and hold circuit (A) is connected to each remaining input of the connectors ($B_i$), whereas the output of each connector ($B_i$) is connected to the input of an comparator ($C_i$), realized as operational amplifier, and whereas the output of each comparator ($C_i$) is connected to an input of a respective voltage limiter ($F_i$). The output of the voltage limiter ($F_i$) is connected to the remaining input of the respective logical circuit ($D_i$), whereas the output of three adjacent logical circuits ($D_i$) are connected to the inputs of a logical checking circuit ($E_i$), which are realized as respective MoT circuits and whose digital outputs are led to an encoder (G) comprising the address of the respective coding word representing the result of the analogue-to-digital conversion.

The output of the encoder (G) is connected to the input of the data processing unit (H), which averages the resulting digital values or code words from the two conversion phases and produces an output signal (h) that represents in many possible applications a desired result of the analogue-to-digital conversion with eliminated effect of offsets of the comparators ($C_i$) and other biases of all said analogue components (B), (K), (M), and (L).

The ADC circuit will be described in more detail with regard to its function and the signals which occur during conversion.

During the first phase the sample and hold circuit (A) will sample one value of the measured signal $y(t)$ and it will produce a constant sampled value $y(n)$. In this phase each connector ($B_i$) is set to its upper position, leading the sampled value to the "+" input of each comparator ($C_i$) and a different reference voltage (comparison voltage) $V_i$ to their "-" inputs. If offsets of all comparators ($C_i$) are zero, the comparators ($C_i$) generate a natural thermometer code.

We consider that $V_k$ denotes the reference voltage closest to the sampled value. Then the k lowest comparators will be set to $+ V_{cc}$ because their reference voltage will be lower than the sampled signal, while all remaining upper comparators ($C_{k+1}$ to $C_2{}^m$) will be triggered to $-V_{cc}$ because their reference voltage is higher than the sampled signal. The value of $k$ depends only on the current value of input signal $y(n)$.

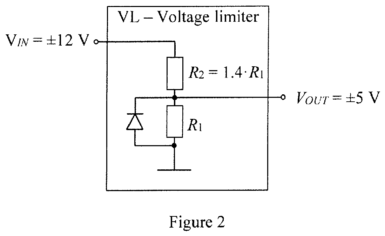

Figure 2 illustrates the design of a voltage limiter ($F_i$). The voltage limiters ($F_i$) produce logical "1s" at +5 V (TTL level) from $+V_{cc}$, and logical "0s" at 0 V (TTL level) from $- V_{cc}$. However, if the comparators ($C_i$) are designed as operational amplifiers being unipolar with TTL logical levels then the voltage limiters ($F_i$) can be omitted. Voltage limiters ($F_i$) can also be combined with or followed by low pass filters to eliminate high-frequency switching noise of the connectors ($B_i$). One input pin of each logical circuit ($D_i$) is connected to the signal (b) of the first clock (J) and will be set to logical "0" during this phase, making all logical circuits ($D_i$) "logically neutral". Logical checking circuits ($E_i$) consisting of MoT (majority-of-three) gates create a proper thermometer code even in cases of bubble errors. The up-most logical checking circuit ($E_i$) has an added fixed "0" input to preserve the resolution of the ADC circuit.

The encoder (G) can be a either a combinatory circuit or a memory block addressed by the logical checking circuits ($E_i$). Signal (g) is the result of the conversion which represents a $k^{th}$ code word of the encoder (G).

If one assumes that the $k^{th}$ code word is equal to k and there is an offset present in the $k^{th}$ comparator ($C_k$) realized as operational amplifier, then the resulting code word will depend on the difference of the sampled signal and the offset of ($C_k$) is given by: $y(n) - offset_k$. If the offset is positive and large enough, it can happen that for some values of the input signal the comparator ($C_k$) will not be triggered and the encoder (G) will generate the $(k-1)^{th}$ code word: k-1. If the offset is negative or too small, then the resulting code word will still be $k$.

During the second phase of the conversion, the ADC circuit uses the same sampled value $y(n)$ as in the first phase. But now, the connectors ($B_i$) are set to position (2) by the CLK signal (a), leading reference voltages $V_i$ to "+" inputs of each respective comparator ($C_i$) and the sampled signal to all "-" inputs. In this way, the resulting code word will depend on the sum of the sampled signal and the offset of the comparator ($C_k$) is given by: $y(n) + offset_k$. If the offset is positive or small enough, the ADC circuit will still generate the code word k. If the offset is negative and significant, it can happen that for some values of the input signal the signal of the comparator ($C_k$) will not be set to $+V_{cc}$, but rather to $-V_{cc}$ and the encoder (G) will generate the code word $k$-1.

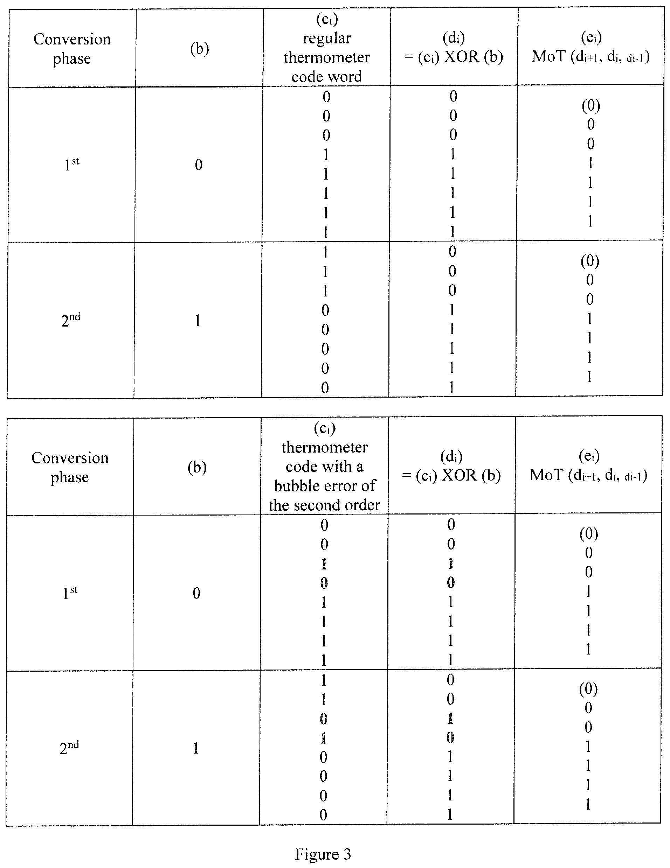

In the second phase of the conversion, the outputs of all comparators ($C_i$) are inverted because their inputs have been inverted. The resulting "inversed thermometer" code determined by signals ($c_i$ of the comparators ($C_i$) has to be correct and for that purpose each logical circuit ($D_i$ has one input set to "1". This is accomplished by connecting this input to the signal (b) of the first clock (J) to invert all logical states and obtain the desired regular thermometer code before feeding it to the logical checking circuits ($E_i$. This is illustrated in figure 3.

The output code word (g) of the two conversions is sent to the data processing unit (H). Because each sample of the signal is converted twice, it is necessary to average out code words of both phases. This is realized by the data processing unit (H) realized as an adder-based shift register. This register shifts the converted value (g) one bit to the right (SHR 1) and adds this value to its previous content. It is necessary to set this register to zero at the beginning of the conversion through its RESET signal driven by signal (b) of the first clock (J). In binary representation shifting one bit to the right is equal to a division by 2. It is therefore clear, that regardless of the sign or the magnitude of the offset, a statistically averaged output will be given by:

$$[y(n) - offset_k + y(n) + offset_k] / 2 = y(n)$$

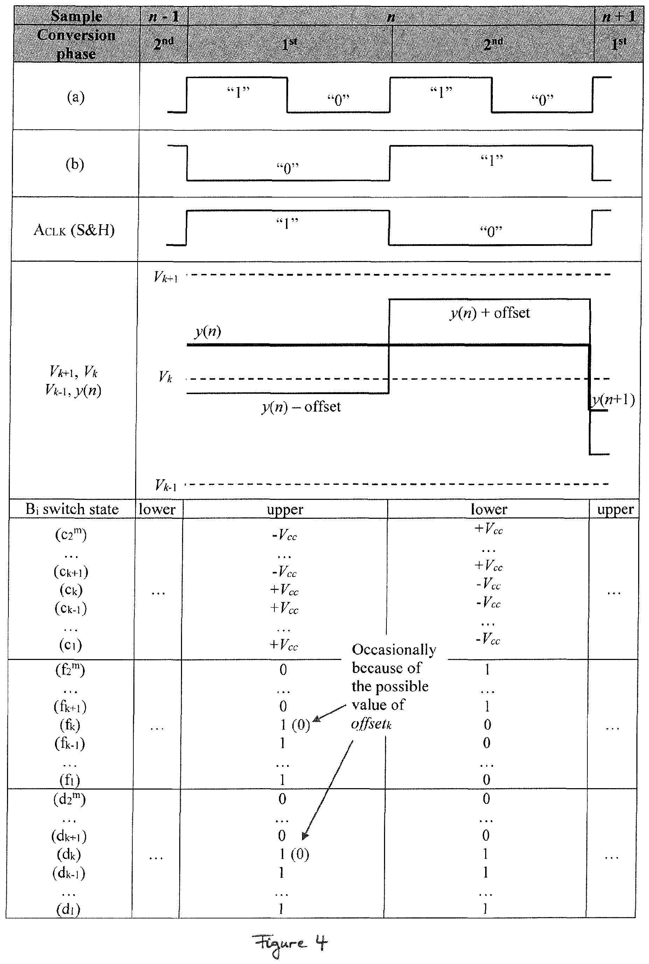

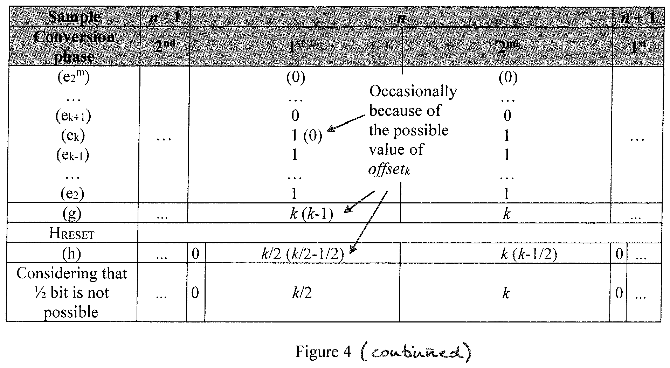

An example of values of analogue signals and logical values of logical circuits is illustrated in figure 4. For the sake of presenting signals a specific value of $y(n)$ had to be assumed without the loss of the generalization of the overall principal of operation.

## Claims

1. A parallel ADC circuit comprising

   - a reference voltage ladder (M) providing a plurality of reference voltages,
   - comparators (C) each comprising two inputs, one coupled to an input terminal receiving a signal corresponding to an analogue input signal and coupled to the reference voltage ladder (M), and
   - an encoder (G) coupled to the comparators (C),

   **characterised by**
   connectors (B) capable of toggling the inputs of the comparators (C).

2. Parallel ADC circuit recited in claim 1, wherein the comparators (C) are formed as operational amplifiers.

3. Parallel ADC circuit recited in claim 1 or 2, further comprising logical circuits (D), the logical circuits (D) comprising a first input coupled to the output of one of the operational amplifiers (C) and an output coupled to the encoder (G).

4. Parallel ADC circuit recited in one of the claims 1 to 3, wherein a first clock (J) is coupled to a sample and hold circuit (A) and the logical circuits (D), the sample and hold circuit (A) for providing an analogue input signal, and the first clock (J) having a frequency half of the frequency of a second clock (O), the second clock (O) being coupled to the first clock (J) and coupled to the connectors (B).

5. Parallel ADC circuit recited in claim 4, wherein the first clock (J) comprises a JK-flip-flop.

6. Parallel ADC circuit recited in one of the aforementioned claims, further comprising a data processing unit (H) receiving signals coupled to the encoder (G).

**7.** Parallel ADC circuit recited in claim 6, wherein the data processing unit (H) is capable of performing an addition and/or a multiplication, preferably an averaging operation of the received data.

**8.** Parallel ADC circuit recited in claim 6 or 7, wherein the data processing unit (H) comprises an adder-based shift register.

**9.** Parallel ADC circuit recited in one of the aforementioned claims, further comprising one or more voltage limiters (F) and/or one or more logical checking circuit (E) coupled between the output of one or more operational amplifier (C) and the encoder (G).

**10.** Parallel ADC circuit recited in claim 9, wherein the logical checking circuit (E) comprises a majority-of-three logical circuit coupled between the output of the logical circuits (D) and the encoder (G).

**11.** Parallel ADC circuit recited in claim 9 or 10, further comprising a low pass filter coupled to one or more of the voltage limiters (F).

**12.** Use of a circuit for converting an analogue signal to a digital signal, said circuit comprising comparators (B), **characterized by** performing a first AD-conversion with the comparators (B), and performing a second AD-conversion with toggled inputs of the comparators (B), wherein the averaged result of the two AD-conversions is used.

**13.** A method for converting an analogue signal to a digital signal, using comparators (B), **characterized by** performing a first AD-conversion with the comparators (B), and performing a second AD-conversion with toggled inputs of the comparators (B), wherein the results of the two AD-conversions is averaged.

Figure 1

$V_{IN} = \pm12\ V$

VL – Voltage limiter

$R_2 = 1.4 \cdot R_1$

$V_{OUT} = \pm5\ V$

$R_1$

Figure 2

| Conversion phase | (b) | $(c_i)$ regular thermometer code word | $(d_i)$ = $(c_i)$ XOR (b) | $(e_i)$ MoT $(d_{i+1}, d_i, d_{i-1})$ |
|---|---|---|---|---|
| 1st | 0 | 0<br>0<br>0<br>1<br>1<br>1<br>1 | 0<br>0<br>0<br>1<br>1<br>1<br>1 | (0)<br>0<br>0<br>1<br>1<br>1<br>1 |
| 2nd | 1 | 1<br>1<br>1<br>0<br>0<br>0<br>0 | 0<br>0<br>0<br>1<br>1<br>1<br>1 | (0)<br>0<br>0<br>1<br>1<br>1<br>1 |

| Conversion phase | (b) | $(c_i)$ thermometer code with a bubble error of the second order | $(d_i)$ = $(c_i)$ XOR (b) | $(e_i)$ MoT $(d_{i+1}, d_i, d_{i-1})$ |
|---|---|---|---|---|
| 1st | 0 | 0<br>0<br>1<br>0<br>1<br>1<br>1 | 0<br>0<br>1<br>0<br>1<br>1<br>1 | (0)<br>0<br>0<br>1<br>1<br>1 |
| 2nd | 1 | 1<br>1<br>0<br>1<br>0<br>0<br>0 | 0<br>0<br>1<br>0<br>1<br>1<br>1 | (0)<br>0<br>0<br>1<br>1<br>1 |

Figure 3

| Sample | $n-1$ | $n$ | | $n+1$ |
|---|---|---|---|---|
| Conversion phase | 2nd | 1st | 2nd | 1st |

| | | | | |
|---|---|---|---|---|
| (a) | | "1"    "0" | "1"    "0" | |
| (b) | | "0" | "1" | |
| $A_{CLK}$ (S&H) | | "1" | "0" | |
| $V_{k+1}, V_k$ $V_{k-1}, y(n)$ | | $V_{k+1}$ ---- $y(n)$ $V_k$ ---- $y(n)-\text{offset}$ | $y(n)+\text{offset}$ $V_{k-1}$ ---- | $y(n+1)$ |

| $B_i$ switch state | lower | upper | lower | upper |
|---|---|---|---|---|
| $(c_2^m)$ | | $-V_{cc}$ | $+V_{cc}$ | |
| ... | | ... | ... | |
| $(c_{k+1})$ | | $-V_{cc}$ | $+V_{cc}$ | |
| $(c_k)$ | ... | $+V_{cc}$ | $-V_{cc}$ | ... |
| $(c_{k-1})$ | | $+V_{cc}$ | $-V_{cc}$ | |
| ... | | ... | | |
| $(c_1)$ | | $+V_{cc}$ | $-V_{cc}$ | |
| $(f_2^m)$ | | 0 | 1 | |
| ... | | ... | ... | |
| $(f_{k+1})$ | | 0 | 1 | |
| $(f_k)$ | ... | 1 (0) | 0 | ... |
| $(f_{k-1})$ | | 1 | 0 | |
| ... | | ... | ... | |
| $(f_1)$ | | 1 | 0 | |
| $(d_2^m)$ | | 0 | 0 | |
| ... | | ... | ... | |
| $(d_{k+1})$ | | 0 | 0 | |
| $(d_k)$ | ... | 1 (0) | 1 | ... |
| $(d_{k-1})$ | | 1 | 1 | |
| ... | | ... | ... | |
| $(d_1)$ | | 1 | 1 | |

Occasionally because of the possible value of $\text{offset}_k$

Figure 4

| Sample | n - 1 | | n | | | n + 1 |
|---|---|---|---|---|---|---|
| Conversion phase | 2nd | | 1st | 2nd | | 1st |
| $(e_2{}^m)$ | | | (0) | (0) | | |
| ... | | | ... | ... | | |
| $(e_{k+1})$ | | | 0 | 0 | | |
| $(e_k)$ | ... | | 1 (0) | 1 | | ... |
| $(e_{k-1})$ | | | 1 | 1 | | |
| ... | | | ... | ... | | |
| $(e_2)$ | | | 1 | 1 | | |
| (g) | ... | | $k$ ($k$-1) | $k$ | | ... |
| $H_{RESET}$ | | | | | | |
| (h) | ... | 0 | $k/2$ ($k/2$-1/2) | $k$ ($k$-1/2) | 0 | ... |
| Considering that ½ bit is not possible | ... | 0 | $k/2$ | $k$ | 0 | ... |

Occasionally because of the possible value of $offset_k$

Figure 4 (continued)

Europäisches
Patentamt

European
Patent Office

Office européen
des brevets

# EUROPEAN SEARCH REPORT

Application Number

EP 17 17 4584

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ERIC FOGLEMAN ET AL: "A Dynamic Element Matching Technique for Reduced-Distortion Multibit Quantization in Delta-Sigma ADCs", IEEE TRANSACTIONS ON CIRCUITS AND SYSTEMS II: ANALOG AND DIGITALSIGNAL PROCESSING, vol. 48, no. 2, February 2001 (2001-02), pages 158-170, XP055310871, 345 EAST 47 STREET, NEW YORK, N.Y. 10017, USA ISSN: 1057-7130, DOI: 10.1109/82.917784 * Section II * * Section III.Introduction * * Section III.A * * figures 1,3 * | 1-13 | INV. H03M1/06 ADD. H03M1/36 H03M1/08 |
| X | US 6 816 100 B1 (GALTON IAN [US] ET AL) 9 November 2004 (2004-11-09) * column 8, lines 6-29 * * figure 4 * | 1-13 | |

| | | | TECHNICAL FIELDS SEARCHED (IPC) |
|---|---|---|---|
| | | | H03M |

The present search report has been drawn up for all claims

| Place of search | Date of completion of the search | Examiner |
|---|---|---|
| The Hague | 14 November 2017 | Rocha, Daniel |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 17 4584

This annex lists the patent family members relating to the patent documents cited in the above-mentioned European search report.
The members are as contained in the European Patent Office EDP file on
The European Patent Office is in no way liable for these particulars which are merely given for the purpose of information.

14-11-2017

| Patent document cited in search report | Publication date | Patent family member(s) | Publication date |
|---|---|---|---|
| US 6816100 B1 | 09-11-2004 | NONE | |

For more details about this annex : see Official Journal of the European Patent Office, No. 12/82

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6518898 B1
- US 7193545 B2